Europäisches Patentamt

European Patent Office

Office européen des brevets

(19)

(11) **EP 0 690 623 B1**

(12) **FASCICULE DE BREVET EUROPEEN**

(45) Date de publication et mention
de la délivrance du brevet:
**21.07.1999 Bulletin 1999/29**

(51) Int Cl.⁶: **H04N 7/087**, H04N 7/24,
H04N 7/54, H03J 3/16,
H03H 17/06, H04J 3/16

(21) Numéro de dépôt: **95401468.4**

(22) Date de dépôt: **21.06.1995**

(54) **Procédé et dispositif d'insertion de données asynchrones sur un signal numérique**

Verfahren und Einrichtung zur Einfügung von asynchronen Daten in ein digitales Signal

Method of and device for inserting asynchronous data into a digital signal

(84) Etats contractants désignés:
**DE FR GB IT**

(30) Priorité: **01.07.1994 FR 9408195**

(43) Date de publication de la demande:
**03.01.1996 Bulletin 1996/01**

(73) Titulaire: **THOMSON multimedia**
**92648 Boulogne Cédex (FR)**

(72) Inventeur: **Le Garrec, Thomas**
**F-92050 Paris la Defence (FR)**

(74) Mandataire: **Ruellan-Lemonnier, Brigitte et al**
**THOMSON multimedia,**
**46 quai A. Le Gallo**
**92648 Boulogne Cédex (FR)**

(56) Documents cités:
**EP-A- 0 144 077**          **EP-A- 0 390 531**
**EP-A- 0 512 619**          **US-A- 4 888 768**
**US-A- 5 182 633**

EP 0 690 623 B1

## Description

L'invention concerne un procédé et un dispositif d'insertion de données numériques ayant un premier débit dans un flux de données numériques ayant un second débit supérieur au premier. L'invention s'applique à l'insertion de données télétexte dans un signal vidéo numérisé.

Classiquement, lors d'une transmission "analogique", les données télétexte sont insérées dans le signal vidéo composite analogique dans les lignes de l'intervalle de retour trame.

Dans des systèmes de compression d'images, les données correspondant à l'image et les données supplémentaires telles que les données télétexte peuvent être transmises dans des paquets différents. Or, certains récepteurs comportent des décodeurs télétexte. Pour éviter une redondance de la fonction télétexte dans le décodeur des signaux compressés, on restitue au récepteur un signal vidéo analogique comprenant les données télétexte.

Or, le débit des données télétexte est de 6.9375 Mbit/s, tandis que le débit d'une source vidéo au standard numérique CCIR 601 est de 13.5 MHz pour la luminance.

L'invention a pour objet un procédé d'insertion d'échantillons représentant des données numériques issues d'une première source ayant un premier débit dans un signal numérisé issu d'une seconde source ayant un second débit, caractérisé en ce que le second débit étant supérieur au premier débit, on associe chaque donnée de la première source à au moins un échantillon d'une série d'échantillons au second débit, les échantillons étant présentés à un filtre polyphase dont chaque jeu de coefficients est associé à une erreur de phase donnée précédemment introduite par ladite association, l'erreur de phase correspondant au retard entre la position théorique d'un bit issu de la source binaire et l'échantillon auquel il est associé, les échantillons filtrés étant inclus dans le signal numérisé.

Le terme "inclusion" ne se limite pas au remplacement d'échantillons du signal numérisé par multiplexage avec des échantillons filtrés, mais comprend aussi notamment l'addition des échantillons filtrés aux échantillons du signal numérisé.

Selon un mode de réalisation particulier de l'invention, les jeux de coefficients du filtre sont déduits de la représentation souhaitée des données issues de la première source dans le signal numérisé.

Selon un mode de réalisation particulier de l'invention, le filtre polyphase comprend une mémoire comportant les résultats possibles du filtrage, ladite mémoire étant adressée, pour chaque échantillon courant de la fenêtre de convolution du filtre, d'une part par une information représentant l'erreur de phase associée à cet échantillon et d'autre part par une information représentant le contenu de la fenêtre de convolution.

Selon un mode de réalisation particulier de l'invention, l'association des données de la première source avec des échantillons dont le débit est celui de la seconde source est réalisée de façon à ce qu'en moyenne, une donnée de la première source soit associée sensiblement à Q échantillons, où

$$Q = Fp/Fb$$

et où Fb et Fp sont respectivement les débits de la première et de la seconde source.

Selon un mode de réalisation particulier de l'invention, l'association des données de la première source avec des échantillons dont le débit est celui de la seconde source est réalisée de façon à ce que M données issues de la première source soient associées à N échantillons, où M et N sont les plus petits entiers vérifiant

$$Fp/Fb = N/M$$

et où Fb et Fp sont respectivement les débits de la première et de la seconde source.

Selon un mode de réalisation particulier de l'invention, une donnée de la première source est répétée tant que le taux de répétition théorique est inférieur au taux de répétition courant, le taux de répétition théorique étant le rapport Fp/Fb, le taux de répétition courant étant le rapport entre le nombre d'échantillons émis et le nombre de données différentes émises par la première source.

Selon un mode de réalisation particulier de l'invention, parmi les échantillons portant une même donnée issue de la première source, tous sauf un sont forcés à la valeur nulle.

Selon un mode de réalisation particulier de l'invention, l'échantillon maintenu à sa valeur initiale est le premier échantillon portant ladite donnée issue de la première source.

Selon un mode de réalisation particulier de l'invention, lesdits échantillons émis au débit de la seconde source portent une donnée issue de la première source lorsque le taux de répétition théorique devient supérieur au taux de répétition courant, le taux de répétition théorique étant le rapport Fp/Fb, le taux de répétition courant étant le rapport entre le nombre d'échantillons émis et le nombre de données différentes émises par la première source, et en ce que tous les autres échantillons portent une valeur nulle.

Selon un mode de réalisation particulier de l'invention, certains échantillons étant répétés X fois, où X est égal au rapport de répétition théorique arrondi à l'entier le plus proche, le premier échantillon suivant une série d'échantillons associés à une donnée non répétée X fois est dit en rupture de phase.

Selon un mode de réalisation particulier de l'invention, les échantillons présentés au filtre polyphase sont décalés de façon à ce qu'aucune rupture de phase n'apparaisse dans la fenêtre de convolution.

Selon un mode de réalisation particulier de l'invention, la série d'échantillons traverse la fenêtre de convolution du filtre polyphase, ladite fenêtre comportant un échantillon dit échantillon courant,

- tant qu'aucun échantillon en rupture de phase n'a pénétré dans la fenêtre de convolution, aucune modification des échantillons n'a lieu,
- lorsqu'un échantillon en rupture de phase est à gauche de l'échantillon courant, lui et ses successeurs sont décalés d'un échantillon vers la gauche,
- lorsqu'un échantillon en rupture de phase est l'échantillon courant ou qu'il se situe à droite de l'échantillon courant, ses prédécesseurs sont décalés d'un échantillon vers la droite.

Selon un mode de réalisation particulier de l'invention, ladite première source est une source binaire de données télétexte.

Selon un mode de réalisation particulier de l'invention, ledit signal numérisé est un signal au standard numérique CCIR 601.

Selon un mode de réalisation particulier de l'invention, ladite représentation souhaitée est similaire à l'impulsion correspondant à un bit définie dans la spécification du Teletexte.

Selon un mode de réalisation particulier, les jeux de coefficients sont définis par:

$$C(P,X) = k*(0.5 + 0.5Cos(\pi(m*X + Fp*P))$$

où

X représente un coefficient à l'intérieur d'un jeu
P représente l'erreur de phase associée à ce jeu et où
k est une constante
m est une constante dépendant du nombre de coefficients par jeu

L'invention a aussi pour objet un dispositif d'insertion d'échantillons représentant des données numériques issues d'une première source ayant un premier débit dans un signal numérisé Issu d'une seconde source ayant un second débit, caractérisé en ce que,

le second débit étant supérieur au premier débit, ledit dispositif comprend des moyens d'association des données issues de la première source à un ou plusieurs échantillons au débit de la seconde source,
des moyens de filtrage polyphase desdits échantillons dont les jeux de coefficients dépendent des erreurs de phase prédédemment introduites par ladite association, l'erreur de phase correspondant au retard entre la position théorique d'un bit issu de la source binaire et l'échantillon auquel il est associé,
des moyens d'inclusion des échantillons filtrés dans le signal numérisé.

Selon un mode de réalisation particulier de l'invention, lesdits moyens d'association comprennent des moyens de mémorisation du nombre d'échantillons à associer avec chaque donnée issue de la première source.

Selon un mode de réalisation particulier de l'invention, le dispositif comprend également des moyens de décimation de la séquence d'échantillons portant les données Issues de la première source, lesdits moyens de décimation forçant à zéro tous les échantillons portant la même donnée, sauf un échantillon.

Selon un mode de réalisation particulier de l'invention, le dispositif comprend également un registre à décalage et des moyens de multiplexage commandés de façon à ce que les échantillons présentés au filtre ne présentent pas de rupture de phase.

Selon un mode de réalisation particulier de l'invention, les moyens de filtrage polyphase comprennent des moyens de mémorisation des résultats possibles dudit filtrage, lesdits moyens de mémorisation étant addressés grâce au contenu de la fenêtre de convolution du filtre et grâce aux erreurs de phase associés à chaque échantillon.

L'invention a aussi pour objet un procédé d'insertion d'échantillons représentant des premières données numériques ayant un premier débit dans un signal numérisé ayant un second débit, caractérisé en ce que

le second débit étant supérieur au premier débit,

on associe chacune des premières données à au moins un échantillon au second débit

on apporte une correction des premières données en fonction de l'erreur de phase introduite par ladite association, l'erreur de phase correspondant au retard entre la position théorique d'un bit issu de la source binaire et l'échantillon auquel il est associé, et

on insère lesdites premières données ainsi corrigées à la place des échantillons auxquels elles sont associées.

Selon un mode de réalisation particulier, ladite correction est réalisée par un filtre polyphase dont chaque jeu de coefficients est associé à une erreur de phase précédemment introduite par ladite association.

D'autres caractéristiques et avantages de l'invention apparaîtront à travers la description d'un exemple particulier non limitatif illustré par les figures jointes, parmi lesquelles:

- la figure 1 est la représentation d'une impulsion correspondant à un bit vrai selon la spécification télétexte,
- la figure 2 est un diagramme fonctionnel du dispositif conforme à l'invention,
- la figure 3 est un diagramme montrant l'accumulation des erreurs de phase au cours d'une partie d'un cycle,
- la figure 4a illustre la répartition de données Issues de la première source sur les échantillons,
- la figure 4b illustre la décimation réalisée sur ces échantillons,
- la figure 4c illustre le signal de restauration indiquant les sauts de phase,
- la figure 5 est un schéma fonctionnel du registre à décalage et du multiplexage réalisé pour éviter les sauts de phase dans la fenêtre de convolution,
- la figure 6 est un schéma illustrant la fenêtre de convolution lorsqu'un seul échantillon en rupture de phase y pénètre,
- la figure 7 représente une courbe utilisée pour déterminer les jeux de coefficients du filtre.

Selon le présent mode de réalisation, le signal numérisé est un signal vidéo au standard numérique CCIR 601, le débit étant de 13,5 MHz (correspondant à 13,5 Moctet/s) pour la luminance. L'information télétexte est un signal binaire de débit 6,9375 Mbit/s.

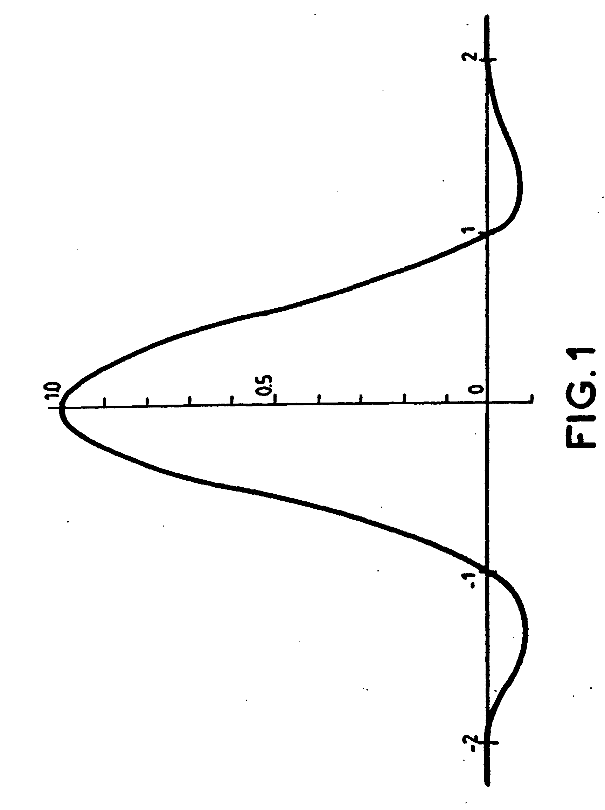

La figure 1 montre la forme d'une impulsion correspondant à un bit de valeur 1 selon la spécification télétexte. Un bit du signal binaire mentionné au paragraphe précédent devra donc être traité de façon à inclure dans le signal vidéo numérisé des échantillons tels que, une fois le signal vidéo numérisé retransformé en signal analogique, les échantillons correspondant à ce bit donneront dans le domaine analogique une impulsion sensiblement proche de celle préscrite par la spécification télétexte.

On dénommera par la suite Fp le débit de la source vidéo numérique et Fb le débit de la source de bits télétexte. Selon le présent exemple, Fp est pris égal à 27MHz, étant donné que les composantes Y, U, V sont multiplexées temporellement et que chacune des composantes U, V a un débit de 6.75 Moctets/s.

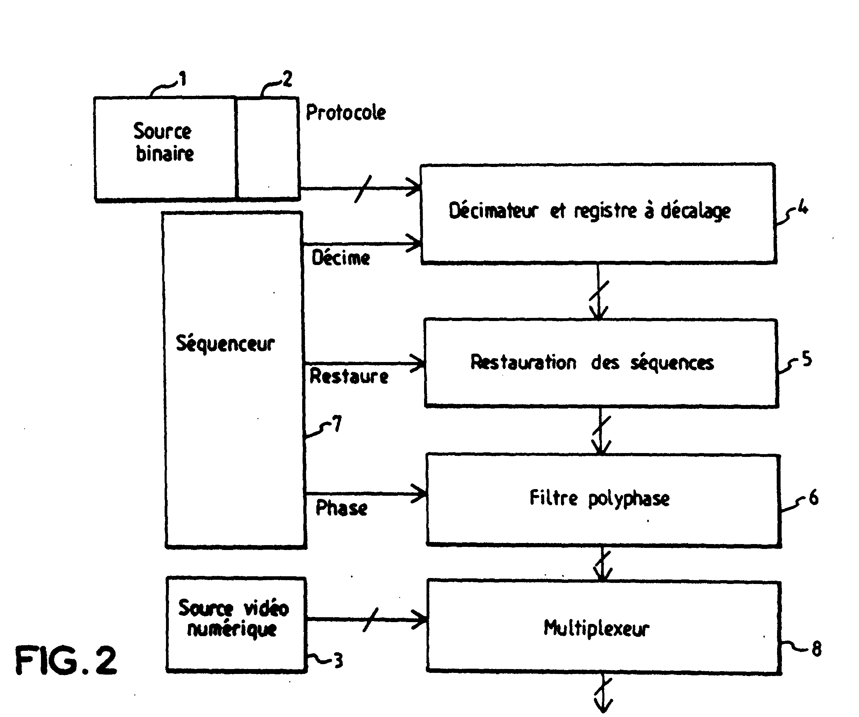

La figure 2 montre un diagramme fonctionnel du dispositif conforme à l'invention. Une source binaire 1 fournit les informations télétexte sous la forme d'une série de bits à son débit propre Fb. Ces informations sont stockées dans une mémoire tampon et lues grâce à un protocole, qui fournit un train de bits à la cadence Fp des échantillons de la source vidéo numérique 3 à un décimateur et registre de décalage 4. Le registre à décalage présente en parallèle un certain nombre de bits à un restaurateur de séquence 5. Le rôle de ce restaurateur sera expliqué ultérieurement. Le nombre de bits en parallèle à la sortie du restaurateur 5 est le même qu'à la sortie du registre 4 et correspond à la fenêtre de convolution d'un filtre 6, qui selon le présent exemple de réalisation est un filtre polyphase. Le signal en sortie du filtre est un signal codé par autant de bits que l'est le signal vidéo numérique. Selon le présent exemple, le signal vidéo numérique est codé sur 8 bits.

Un circuit séquenceur 7 produit des signaux "Décime" et "Restaure" et "Phase" contrôlant respectivement les circuits 4, 5 et 6. Il est synchronisé sur les signaux de synchronisation horizontaux et verticaux du signal vidéo numérisé.

Les échantillons filtrés sont multiplexés dans le signal numérisé par un multiplexeur 8.

Le rôle du protocole est de rétablir au mieux la même échelle temporelle pour les échantillons de la source vidéo numérique et les valeurs binaires issues de la mémoire tampon 2. Etant donné que la source binaire débite plus lentement que la source vidéo numérique, un même bit issu de la source binaire pourra être fourni plus d'une fois par le protocole pour être associé à plus d'un échantillon. Il s'agit "d'étaler" temporellement les bits issus de la source binaire sur un ou plusieurs échantillons à la fréquence Fp.

Par exemple, si le rapport entre Fp et Fb était de 3, un bit issu de la source binaire serait répété par le protocole exactement pendant trois échantillons à la fréquence Fp.

De manière plus générale, on définit les deux plus petits entiers M et N vérifiant:

$$Fp/Fb = N/M \text{ ou encore } N/Fp = M/Fb$$

Dans le cas général, le rapport N/M sera non entier. Dans le cas du présent exemple de réalisation, on trouve N=144 et M=37, soit N/M = 3.89189. Ce rapport est dénommé taux de répétition théorique par la suite: n'étant pas entier dans le cas présent, il est bien évident que l'on ne pourra s'y tenir de manière rigoureuse, une répétition "partielle" d'une valeur binaire n'étant pas possible. Il s'en suit que, pour qu'en moyenne ce taux soit respecté, certains bits seront répétés plus souvent que d'autres.

Dans le cas du télétexte, un bit issu de donnée télétexte sera associé à environ 4 échantillons, 4 étant l'entier le plus proche du rapport N/M.

L'étalement effectué par le protocole sera en moyenne exactement égal à N/M tous les cycles de M bits à la fréquence Fb, ou encore tous les cycles de N échantillons à la fréquence Fp, la période N/Fp étant égale à la période M/Fb. L'objectif du taux de répétition théorique sera donc atteint en moyenne sur M bits répartis sur N échantillons.

Selon le présent exemple de réalisation, le protocole est conçu pour se rapprocher, au niveau de chaque bit émis par le protocole, assez près du taux de répétition théorique. De cette façon le gigue de phase introduite est minimisée. La phase dont on parle ici peut être définie comme le retard entre la position théorique d'un bit issu de la source binaire et l'échantillon auquel il est associé.

Selon le présent exemple de réalisation, le protocole est défini de la façon suivante:

**DEBUT**

       **Emettre le premier bit**

       **Calculer le taux de répétition courant**

       **SI (Taux de répétition courant < Taux de répétition théorique) ALORS**

              **Répéter dernier bit émis**

       **SINON**

              **Emettre bit suivant**

       **FIN SI**

**FIN**

Le taux de répétition courant est défini comme étant le rapport entre le nombre d'échantillons émis par la source depuis le début du cycle et le nombre de bits différents émis par le protocole depuis le début du cycle.

L'algorithme présenté ci-dessus est particulièrement simple, mais d'autres protocoles peuvent également être adoptés.

Un cycle selon l'algorithme décrit sera de la forme:

Tableau 1

| Numéro de bit émis par le protocole/ Numéro de l'échantillon | | | | | |
|---|---|---|---|---|---|
| 1/1 | 7/25 | 13/49 | 19/73 | 25/97 | 31/121 |
| 1/2 | 7/26 | 13/50 | 19/74 | 25/98 | 32/122 |
| 1/3 | 7/27 | 13/51 | 20/75 | 26/99 | 32/123 |
| 1/4 | 7/28 | 14/52 | 20/76 | 26/100 | 32/124 |
| 2/5 | 8/29 | 14/53 | 20/77 | 26/101 | 32/125 |
| 2/6 | 8/30 | 14/54 | 20/78 | 26/102 | 33/126 |
| 2/7 | 8/31 | 14/55 | 21/79 | 27/103 | 33/127 |

Tableau 1   (suite)

| Numéro de bit émis par le protocole/ Numéro de l'échantillon | | | | | |
|------|-------|-------|-------|--------|--------|
| 2/8 | 8/32 | 15/56 | 21/80 | 27/104 | 33/128 |
| 3/9 | 9/33 | 15/57 | 21/81 | 27/105 | 33/129 |
| 3/10 | 9/34 | 15/58 | 21/82 | 27/106 | 34/130 |
| 3/11 | 9/35 | 15/59 | 22/83 | 28/107 | 34/131 |
| 3/12 | 9/36 | 16/60 | 22/84 | 28/108 | 34/132 |
| 4/13 | 10/37 | 16/61 | 22/85 | 28/109 | 34/133 |
| 4/14 | 10/38 | 16/62 | 22/86 | 29/110 | 35/134 |
| 4/15 | 10/39 | 16/63 | 23/87 | 29/111 | 35/135 |
| 4/16 | 11/40 | 17/64 | 23/88 | 29/112 | 35/136 |
| 5/17 | 11/41 | 17/65 | 23/89 | 29/113 | 35/137 |
| 5/18 | 11/42 | 17/66 | 23/90 | 30/114 | 36/138 |
| 5/19 | 11/43 | 17/67 | 24/91 | 30/115 | 36/139 |
| 5/20 | 12/44 | 18/68 | 24/92 | 30/116 | 36/140 |
| 6/21 | 12/45 | 18/69 | 24/93 | 30/117 | 36/141 |
| 6/22 | 12/46 | 18/70 | 24/94 | 31/118 | 37/142 |
| 6/23 | 12/47 | 18/71 | 25/95 | 31/119 | 37/143 |
| 6/24 | 13/48 | 19/72 | 25/96 | 31/120 | 37/144 |

Les bits 10, 19, 28 et 37 ne sont répétés que trois fois, tandis que tous les autres bits sont répétés quatre fois. Le fait de ne répéter certains bits que trois fois permet de corriger, par un saut de phase correspondant à la non-répétition, les erreurs de phase Introduits par la répétition d'autres bits quatres fois de suite. Bien entendu, la correction apportée n'est parfaite qu'en fin de cycle.

On avance donc d'un échantillon la première émission des bits 11, 20, 29 et "38", ce dernier bit étant en fait le premier bit du cycle suivant.

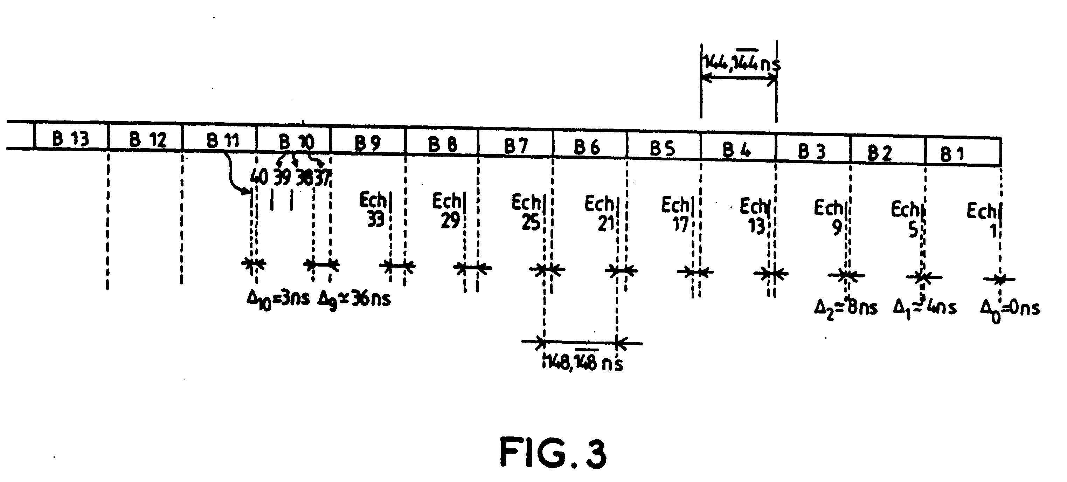

La figure 3 montre la façon dont l'erreur de phase s'accumule de bit en bit et d'échantillon en échantillon. Un bit de donnée télétexte a normalement une durée de $1/Fp=144{,}144$ ns (Bi désigne le ième bit d'un cycle). Réparti sur quatre échantillons, il aura en fait une durée effective de $4/Fb=148{,}148$ ns, soit $4{,}004$ ns supplémentaires. L'échantillon 37, le premier échantillon destiné à être associé au bit 10, aura une avance $\Delta 9=36{,}036$ ns sur ce bit. Le protocole n'associera le bit numéro 10 qu'à trois échantillons au lieu de quatre, ce qui aura pour effet de rattraper partiellement l'avance $\Delta$. La période étant de $1/Fb=37{.}037$ ns, le début du bit suivant, le bit numéro 11, sera cette fois ci en avance de $3{.}003$ ns sur l'échantillon 40. Ce ne sera qu'au 145ème échantillon (premier échantillon du cycle suivant) que les phases coïncideront exactement.

Le tableau 2 indique les avances $\Delta$ pour chaque échantillon d'un cycle à qui un bit nouveau est associé par le protocole.

| Numéro d'échantillon | Retard en ns (tronqué) | Numéro d'échantillon | Retard en ns (tronqué) |
|---|---|---|---|
| 1 | 0 | 75 | 39-37 = 2 |
| 5 | 4 | 79 | 6 |
| 9 | 8 | 83 | 10 |
| 13 | 12 | 87 | 14 |
| 17 | 16 | 91 | 18 |
| 21 | 20 | 95 | 22 |
| 25 | 24 | 99 | 26 |
| 29 | 28 | 103 | 30 |
| 33 | 32 | 107 | 34 |
| 37 | 36 | 110 | 38-37 = 1 |

| 40 | 40-37 = 3 | 114 | 5 |
|---|---|---|---|
| 44 | 7 | 118 | 9 |
| 48 | 11 | 122 | 13 |
| 52 | 15 | 126 | 17 |
| 56 | 19 | 130 | 21 |
| 60 | 23 | 134 | 25 |
| 64 | 27 | 138 | 29 |
| 68 | 31 | 142 | 33 |
| 72 | 35 | 145 | 37-37 = 0 |

**Tableau 2**

Le tableau 2 peut être mémorisé simplement en mémorisant les erreurs de phase associées aux échantillons qui correspondent à une rupture de phase, en l'occurrence les échantillons 1, 40, 75 et 110. Les erreurs de phase correspondant à tous les autres échantillons se déduisent simplement à partir de l'erreur de phase de l'échantillon en rupture précédent le plus proche et à partir du nombre de périodes de Fp entre ces deux échantillons.:

Par exemple, l'erreur de phase associée à l'échantillon 38 est déduite à partir de l'erreur de phase de l'échantillon 1 (en l'occurrence 0 ns) et du fait que 37 périodes 1.001 séparent ces deux échantillons: l'erreur totale sera alors $(0 + 37)*1.001 = 37.037$ ns.

L'erreur associée à l'échantillon 94 sera égale à $(2 + 94 - 75)*1.001 = 21.021$ ns.

Les sauts de phase sont donc introduits sciemment, à des positions connues.

Les positions des bits qui ne sont répétés que trois fois sont les mêmes pour tous les cycles. Selon une variante du présent exemple de réalisation, l'implémentation pratique du protocole se fait sous la forme d'une table de référence qui donne le nombre de répétitions d'un bit en fonction de son numéro d'ordre par rapport au début d'un cycle. Ceci évite le calcul des divisions nécessaires en cas d'implémentation directe de l'algorithme donné ci-dessus. Notamment, il suffit de mémoriser les numéros d'ordre des bits à ne répéter que trois fois. Ceci représente un gain de mémoire important.

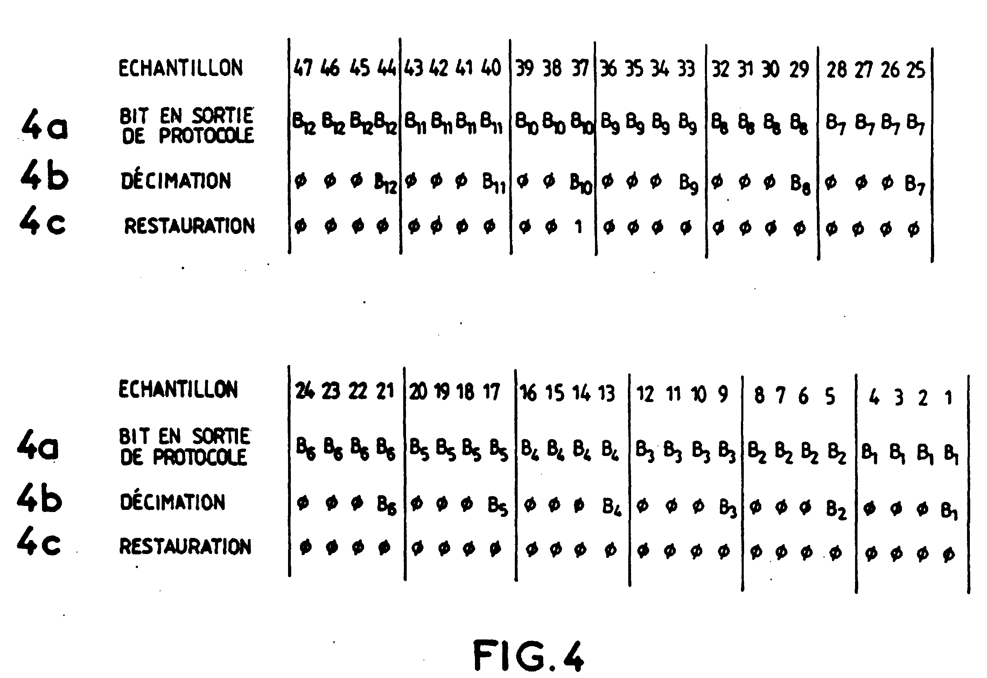

La figure 4a montre les bits répartis sur divers échantillons en sortie de protocole.

Le registre à décalage et décimateur 4 reçoit les bits issus du protocole en série. Le décimateur procède à l'opération suivante: sur une série d'échantillons portant le même bit, tous les échantillons sauf un sont forcés à zéro. Selon le présent exemple de réalisation, la position de l'échantillon qui n'est pas mis à zéro est celle du premier échantillon de la série: c'est l'échantillon dit valide. La figure 4b montre l'effet du décimateur sur le train d'échantillons, une fois dans le registre à décalage. Les valeurs Bi peuvent être à 1 ou à 0. Les valeurs des autres positions sont forcées à zéro. Le registre à décalage permet la mise en parallèle des bits arrivant en série du protocole. Cette mise en parallèle est nécessaire pour le traitement effectué par le circuit restaurateur de séquences 5.

Selon le présent exemple de réalisation, c'est le séquenceur 7 qui élabore un signal "Décime" qui indique au registre à décalage 4 s'il doit accepter un échantillon en provenance du protocole ou s'il doit le forcer à 0.

Dans le présent exemple de réalisation, les fonctions du protocole et du décimateur sont séparées, notamment pour exposer par étapes simples le fonctionnement du dispositif. Selon une variante de réalisation, les fonctions du protocole et du décimateur sont combinées: le protocole émet un bit Bi suivi de un ou de deux zéros, suivant l'information qui lui est fournie par le tableau 1.

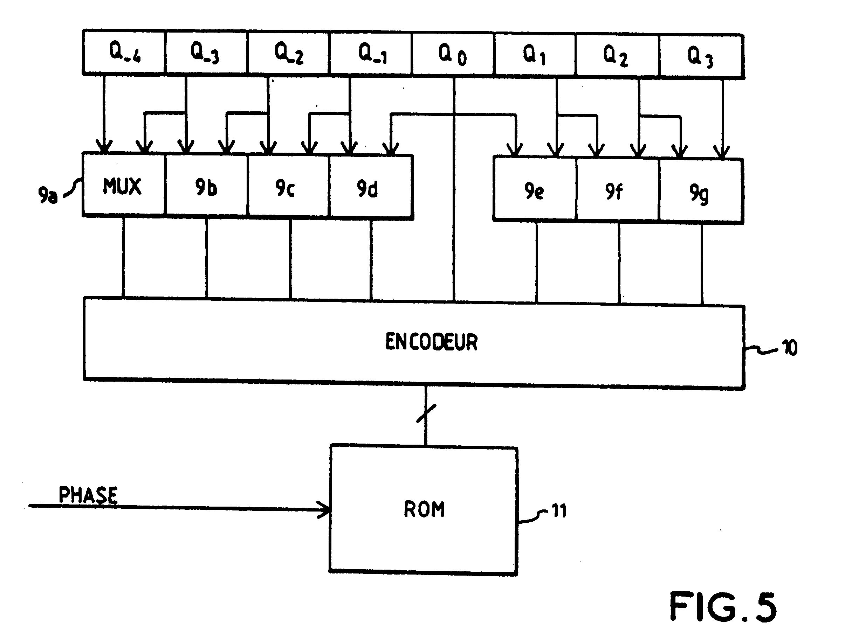

Selon le présent exemple, et tel qu'illustré à la figure 5, le registre à décalage possède une largeur de 8 mémoires à un bit, numérotés de Q-4 à Q3, Q0 étant le bit courant. Le restaurateur de séquences 5 comprend 7 multiplexeurs (9a à 9G) à deux entrées, ces dernières étant connectées de la façon suivante:

Tableau 3

| Multiplexeur | 9a | 9b | 9c | 9d | 9e | 9f | 9g |
|---|---|---|---|---|---|---|---|
| Connections | Q-4, Q-3 | Q-3, Q-2 | Q-2, Q-1 | Q-1, Q0 | Q0, Q1 | Q1, Q2 | Q2, Q3 |

Les sorties de chacun des multiplexeurs ainsi que la sortie de la mémoire Q0 sont connectés à l'entrée d'un encodeur d'adresses 10.

Le contrôle des multiplexeurs est réalisé grâce à l'état d'un signal appelé "Restaure". Il s'agit d'un signal binaire indiquant, parmi les échantillons non décimés précédemment, lesquels ont subi une correction de phase en ayant été avancés d'un échantillon.

La figure 4c montre l'état du signal Restaure par rapport au signal Décime. Dans le cadre du présent exemple de réalisation, Restaure n'est à 1 que pour les échantillons 40, 75, 110 et "145".

Le rôle du restaurateur de séquences est de présenter au filtre une séquence d'échantillons sans rupture de phase, en agissant sur les échantillons présents dans la fenêtre de convolution du filtre. On cherche à éviter la présence, dans cette fenêtre de convolution, d'un échantillon valide par le fait qu'on lui a associé un bit et qui influencerait, de par son avance par rapport au précédent échantillon valide, le traitement de ce dernier par le filtre polyphase.

Selon le présent exemple de réalisation, la fenêtre de convolution a une largeur de 8 bits.

On numérote les positions C de cette fenêtre de manière similaire aux mémoires du registre à décalage 4, c'est à dire de C-4 à C3, C0 étant l'échantillons courant.

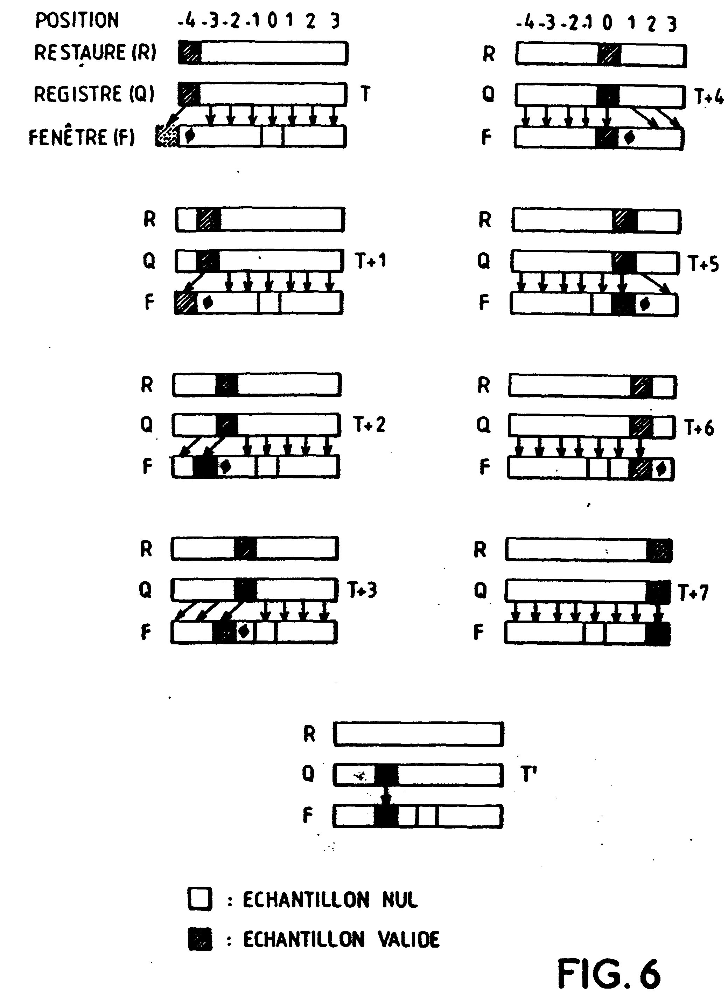

La figure 6 indique les différents cas pouvant se présenter lorsque des échantillons pénètrent dans la fenêtre de convolution.

La position d'un échantillon en rupture de phase est indiquée par le signal "Restaure" ou "R". Le contenu du registre à décalage est indiqué par la ligne "Q", tandis que le contenu de la fenêtre de convolution (en sortie des multiplexeurs) est désigné par "F".

Les huit diagrammes associés aux temps T+1 montrent l'effet, sur le contenu de la fenêtre de convolution, de la traversée du registre de décalage d'un échantillon en rupture de phase.

Le traîtement effectué peut être résumé ainsi:

- tant qu'aucun échantillon en rupture de phase n'a pénétré dans la fenêtre de convolution, les multiplexeurs sont transparents: les contenus de Qi et Fi sont les mêmes (diagramme T' de la figure 6),
- lorsqu'un échantillon en rupture de phase se trouve à gauche de la position courante (positions -4 à -1), lui et ses successeurs sont décalés d'un échantillon vers la gauche, un échantillon nul étant inséré à la position ainsi libérée dans la fenêtre de convolution. Ce décalage est réalisé en agissant sur les multiplexeurs 9a, 9b, 9c et/ou 9d (diagrammes T à T+3 de la figure 6),
- lorsqu'un échantillon se trouve soit à la position courante (position 0), à droite de cette position (1 à 3), alors ses prédécesseurs sont décalés d'un échantillon vers la gauche, un échantillon nul étant inséré à la position ainsi libérée dans la fenêtre de convolution (diagrammes T+4 à T+7).

La commande des multiplexeurs est donc réalisée simplement en analysant comme explicité ci-dessus le signal "Restaure".

Comme mentionné précédemment, la fenêtre de convolution a dans le présent cas une largeur de 8 bits. Il est bien évident qu'une autre largeur de fenêtre est envisageable.

La fenêtre de convolution est utilisée par un filtre polyphase dont le rôle est d'élaborer, à partir des échantillons codés sur un bit de la fenêtre de convolution, des échantillons codés sur huit bits pour l'insertion dans le signal vidéo numérique.

Le filtre polyphase est un filtre dont les coefficients changent d'échantillon en échantillon. Dans le présent cas, 39 jeux de coefficients sont nécessaires, étant donné qu'un échantillon peut avoir une erreur de phase parmi 39 erreurs possibles(n*1.001 ns où n varie de 0 à 38)

Si l'on n'avait pas effectué de sauts de phase, environ quatre fois plus jeux de coefficients auraient été nécessaires.

Les jeux de coefficients sont stockées dans une mémoire morte. Cette mémoire est adressée par le signal "Phase" élaboré par le séquenceur. Ce signal indique, pour chaque échantillon courant, les adresses des coefficients correspondant à l'erreur de phase associée avec cet échantillon.

Les jeux de coefficients sont en principe déduits d'une courbe ayant la forme d'une impulsion telle qu'illustrée par la figure 1. En effet; lorsqu'un échantillon valide dans la fenêtre de convolution est à "1"; cela signifie que dans le domaine analogique, le signal comprendra une impulsion telle que celle de la figure 1.

Il est bien évident que selon l'application, cette forme de signal peut changer.

La courbe de la figure 1, c'est à dire la courbe correspondant à la spécification télétexte est conçue en fonction de certains impératifs de transmission. Dans le cadre de l'exemple de réalisation, c'est au niveau du récepteur que l'insertion des informations télétexte est réalisée. Les contraintes de transmission ne sont donc plus les mêmes.

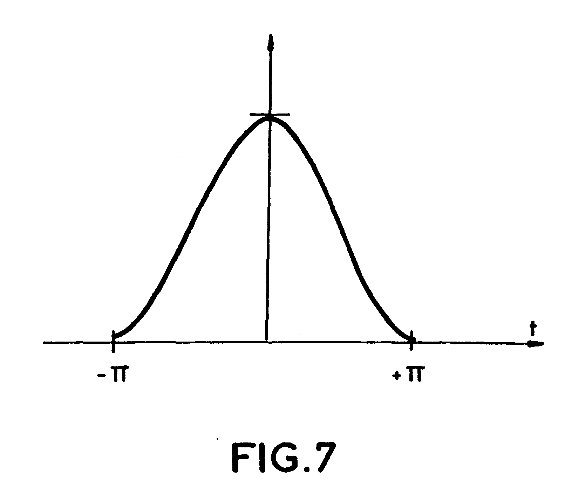

La détermination des coefficients sera dans ce qui suit basée sur la forme de la courbe de la figure 7. La figure 7 représente une période de cosinus translatée selon le sens positif des ordonnées d'une demi-amplitude et dont l'amplitude maximale est positionnée sur cet axe.

Un jeu de coefficients est défini pour une erreur de phase donnée, cette erreur correspondant à un temps en nanosecondes de n*1.001 ns avec n compris entre 0 et 38: pour chaque jeu de coefficients, la courbe sera translatée de cette valeur.

Selon le présent exemple de réalisation, les coefficients sont définis de la manière suivante:

$$C(p,x)=k*(0.5 + 0.5Cos(\pi(0.25X + Fp*P))$$

où

Fp=6.973Mhz
X compris entre -4 et 3
P étant égal à n*1.001 ns,
avec n compris entre 0 et 38,
k constante.

Les coefficients ainsi calculés sont utilisés par le filtre polyphase.

Selon le présent exemple de réalisation, le filtre polyphase comprend une mémoire morte (référence 11 de la figure 5) contenant des coefficients et des sommes de coefficients.

Le tableau 4 montre l'organisation de cette ROM:

Tableau 4

| F-4 | F-3 | F-2 | F-1 | F0 | F1 | F2 | F3 | Sortie d' Encodeur | DATA |
|---|---|---|---|---|---|---|---|---|---|
| 0 | 0 | 0 | 0 | 0 | 0 | 0 | 0 | 0 | 00 |
| 1 | 0 | 0 | 0 | 0 | 0 | 0 | 0 | 1 | C[p,-4] |
| 0 | 1 | 0 | 0 | 0 | 0 | 0 | 0 | 2 | C[p,-3] |
| 0 | 0 | 1 | 0 | 0 | 0 | 0 | 0 | 3 | C[p,-2] |
| 0 | O | 0 | 1 | 0 | 0 | 0 | 0 | 4 | C[p,-1] |
| 0 | 0 | 0 | 0 | 1 | 0 | 0 | 0 | 8 | C[p,0] |
| 1 | 0 | 0 | 0 | 1 | 0 | 0 | 0 | 9 | C[p,0]+C[p,-4] |
| 0 | 0 | O | O | 0 | 1 | 0 | 0 | A | C[p,1] |
| 0 | 1 | 0 | 0 | 0 | 1 | 0 | 0 | B | C[p,1]+C[p;-3] |

Tableau 4   (suite)

| F-4 | F-3 | F-2 | F-1 | F0 | F1 | F2 | F3 | Sortie d' Encodeur | DATA |
|---|---|---|---|---|---|---|---|---|---|
| 0 | 0 | 0 | 0 | 0 | 0 | 1 | 0 | C | C[p,2] |
| 0 | 0 | 1 | 0 | 0 | 0 | 1 | 0 | D | C[p,2]+C[p;-2] |
| 0 | 0 | 0 | 0 | 0 | 0 | 0 | 1 | E | C[p,3] |
| 0 | 0 | 0 | 1 | 0 | 0 | 0 | 1 | F | C[p,3]+ C[p,-1] |

Le tableau 4 montre les treize états possibles de la fenêtre de convolution. Etant donné que dans le cadre du présent exemple de réalisation, les échantillons contenus dans cette fenêtre sont codés sur un seul bit, le filtre polyphase aura essentiellement à effectuer des additions de coefficients. Etant donné d'autre part que la fenêtre de convolution contient au plus deux échantillons ayant la valeur "1", au maximum une addition sera à effectuer pour un échantillon courant donné. En stockant directement dans la mémoire morte le résultat des additions, un additionneur est économisé.

Les treize états de la fenêtre de convolution sont encodés par un encodeur 10 sur 4 bits (voir figure 5). Les 39 phases possibles sont encodées sur 6 bits par le séquenceur. Les 10 bits résultants servent à adresser la mémoire morte; dont la taille est de 39x13 mots de 8 bits.

Il est bien évident que l'invention ne se limite pas au cas où les données issues de la première source à débit Fp sont codées sur un seul bit.

D'autre part, selon le présent exemple, le rapport Fp/Pb est proche de 4. Pour cette raison, la plupart des données issues de la source binaire sont associés à 4 échantillons. Certains sont associés à seulement trois échantillons, ce qui permet de rattraper par un saut de phase relativement important les erreurs de phase introduites en avnçant une donnée d'un échantillon. Il va de soi que lorsque le rapport Fp/Fb est tel que sa partie décimale est inférieure à 0.5, c'est en retardant une donnée d'un échantillon que la correction sera effectuée.

**Revendications**

1.   Procédé d'insertion d'échantillons représentant des données numériques issues d'une première source (1) ayant un premier débit (Fb) dans un signal numérisé issu d'une seconde source (3) ayant un second débit (Fp), caractérisé en ce que

le second débit (Fp) étant supérieur au premier débit (Fb),
on associe chaque donnée (Bi) de la première source (1) à au moins un échantillon d'une série d'échantillons au second débit (Fp),
les échantillons étant présentés à un filtre polyphase (6) dont chaque jeu de coefficients est associé à une erreur de phase (Phase) donnée précédemment introduite par ladite association, l'erreur de phase correspondant au retard entre la position théorique d'un bit issu de la source binaire (1) et l'échantillon auquel il est associé,
les échantillons filtrés étant inclus (8) dans le signal numérisé.

2.   Procédé selon la revendication 1; caractérisé en ce que les jeux de coefficients du filtre (6) sont déduits de la représentation souhaitée des données issues de la première source (1) dans le signal numérisé.

3.   Procédé selon la revendication 2; caractérisé en ce que le filtre polyphase (6) comprend une mémoire (11) comportant les résultats possibles du filtrage, ladite mémoire (11) étant adressée, pour chaque échantillon courant de la fenêtre de convolution (C) du filtre, d'une part par une information (Phase) représentant l'erreur de phase associée à ce filtre et d'autre part par une information (10) représentant le contenu de la fenêtre de convolution.

4.   Procédé selon l'une des revendications précédentes; caractérisé en ce que l'association des données de la première source (1) avec des échantillons dont le débit (Fp) est celui de la seconde source (3) est réalisée de façon à ce qu'en moyenne, une donnée de la première source soit associée sensiblement à Q échantillons, où

$$Q=Fp/Fb$$

et où Fb et Fp sont respectivement les débits de la première et de la seconde source.

**5.** Procédé selon l'une des revendications précédentes; caractérisé en ce que l'association des données de la première source (1) avec des échantillons dont le débit (Fp) est celui de la seconde source est réalisée de façon à ce que M données issues de la première source soient associées à N échantillons, où M et N sont les plus petits entiers vérifiant

$$Fp/Fb = N/M$$

et où Fb et Fp sont respectivement les débits de la première et de la seconde source.

**6.** Procédé selon l'une des revendications 4 ou 5; caractérisé en ce qu'une donnée de la première source (1) est répétée tant que le taux de répétition théorique est inférieur au taux de répétition courant, le taux de répétition théorique étant le rapport Fp/Fb; le taux de répétition courant étant le rapport entre le nombre d'échantillons émis et le nombre de données différentes émises par la première source (1).

**7.** Procédé selon la revendication 6, caractérisé en ce que parmi les échantillons portant une même donnée (Bi) issue de la première source (1), tous sauf un sont forcés à la valeur nulle (Décime).

**8.** Procédé selon la revendication 7, caractérisé en ce que l'échantillon maintenu à sa valeur initiale est le premier échantillon portant ladite donnée issue de la première source.

**9.** Procédé selon l'une des revendications 1 à 3, caractérisé en ce que lesdits échantillons émis au débit (Fp) de la seconde source portent une donnée issue de la première source (1) lorsque le taux de répétition théorique devient supérieur au taux de répétition courant, le taux de répétition théorique étant le rapport Fp/Fb; le taux de répétition courant étant le rapport entre le nombre d'échantillons émis et le nombre de données différentes émises par la première source, et en ce que tous les autres échantillons portent une valeur nulle.

**10.** Procédé selon la revendication 9, caractérisé en ce que certains échantillons étant répétés X fois, où X est égal au rapport de répétition théorique arrondi à l'entier le plus proche, le premier échantillon suivant une série d'échantillons associés à une donnée non répétée X fois est dit en rupture de phase (Restaure).

**11.** Procédé selon la revendication 10, caractérisé en ce que les échantillons présentés au filtre polyphase (6) sont décalés de façon à ce qu'aucune rupture de phase n'apparaisse dans la fenêtre de convolution (C).

**12.** Procédé selon la revendication 10 ou 11, caractérisé en ce que la série d'échantillons traverse la fenêtre de convolution du filtre polyphase (6), ladite fenêtre comportant un échantillon dit échantillon courant,

- tant qu'aucun échantillon en rupture de phase n'a pénétré dans la fenêtre de convolution, aucune modification des échantillons n'a lieu,
- lorsqu'un échantillon en rupture de phase est à gauche de l'échantillon courant, lui et ses successeurs sont décalés d'un échantillon vers la gauche,
- lorsqu'un échantillon en rupture de phase est l'échantillon courant ou qu'il se situe à droite de l'échantillon courant, ses prédécesseurs sont décalés d'un échantillon vers la droite.

**13.** Procédé selon l'une des revendications précédentes, caractérisé en ce que ladite première source (1) est une source binaire de données télétexte.

**14.** Procédé selon l'une des revendications précédentes, caractérisé en ce que ledit signal numérisé est un signal au standard numérique CCIR 601.

**15.** Procédé selon la revendication 2, caractérisé en ce que ladite représentation souhaitée est similaire à l'impulsion correspondant à un bit définie dans la spécification du Teletexte (Figure 1).

**16.** Procédé selon l'une des revendications précédentes, caractérisé en ce que les jeux de coefficients sont définis par:

$$C(P,X)=k*(0.5 + 0.5Cos(\pi(m*X + Fp*P))$$

où

X représente un coefficient à l'intérieur d'un jeu
P représente l'erreur de phase associée à ce jeu et où
k est une constante,
m est une constante dépendant du nombre de coefficients par jeu

17. Dispositif d'insertion d'échantillons représentant des données numériques issues d'une première source ayant un premier débit (Fb) dans un signal numérisé issu d'une seconde source ayant un second débit (Fp), caractérisé en ce que,

le second débit étant supérieur au premier débit, ledit dispositif comprend des moyens d'association (2) des données issues de la première source à un ou plusieurs échantillons au débit (Fp) de la seconde source, des moyens de filtrage polyphase (6) desdits échantillons dont les jeux de coefficients dépendent des erreurs de phase prédédemment introduites par ladite association, l'erreur de phase correspondant au retard entre la position théorique d'un bit issu de la source binaire (1) et l'échantillon auquel il est associé, des moyens d'inclusion (8) des échantillons filtrés dans le signal numérisé.

18. Dispositif selon la revendication 17, caractérisé en ce que lesdits moyens d'association comprennent des moyens de mémorisation du nombre d'échantillons à associer avec chaque donnée issue de la première source.

19. Dispositif selon la revendication 17 ou 18, caractérisé en ce que le dispositif comprend également des moyens de décimation (7) de la séquence d'échantillons portant les données issues de la première source, lesdits moyens de décimation forçant à zéro tous les échantillons portant la même donnée, sauf un échantillon.

20. Dispositif selon l'une des revendications 17 à 19, caractérisé en ce que le dispositif comprend également un registre à décalage (4) et des moyens de multiplexage (9) commandés de façon à ce que les échantillons présentés au filtre ne présentent pas de rupture de phase.

21. Dispositif selon l'une des revendications 17 à 20, caractérisé en ce que les moyens de filtrage polyphase comprennent des moyens de mémorisation (11) des résultats possibles dudit filtrage, lesdits moyens de mémorisation étant addressés grâce au contenu de la fenêtre de convolution (10,C) du filtre et grâce aux erreurs de phase associés à chaque échantillon (Phase).

22. Dispositif selon l'une des revendications 17 à 21, caractérisé en ce qu'il met en oeuvre le procédé selon l'une des revendications 1 à 15.

23. Dispositif selon l'une des revendications 17 à 22, caractérisé en ce que les jeux de coefficients sont définis par:

$$C(P,X)=k*(0.5 + 0.5Cos(\pi(0.25X + Fp*P))$$

où

représente un coefficient à l'intérieur d'un jeu
P représente l'erreur de phase associée à ce jeu et où
k est une constante.

24. Procédé d'insertion d'échantillons représentant des premières données numériques ayant un premier débit (Fb) dans un signal numérisé ayant un second débit (Fp), caractérisé en ce que

le second débit (Fp) étant supérieur au premier débit (Fb),
on associe chacune des premières données (Bi) à au moins un échantillon au second débit (Fp),
on apporte une correction des premières données en fonction de l'erreur de phase introduite par ladite association, l'erreur de phase correspondant au retard entre la position théorique d'un bit issu de la source, binaire (1) et l'échantillon auquel il est associé, et
on insère lesdites premières données ainsi corrigées à la place des échantillons auxquels elles sont associées.

25. Procédé selon la revendication 24, caractérisé en ce que ladite correction est réalisée par un filtre polyphase (6) dont chaque jeu de coefficients est associé à une erreur de phase (Phase) précédemment introduite par ladite association.

**Patentansprüche**

1. Verfahren zur Einfügung von Abtastwerten, die digitale Daten von einer ersten Quelle (1) mit einer ersten Datenrate (Fb) darstellen, in ein digitales Signal von einer zweiten Quelle (3) mit einer zweiten Datenrate (Fp), dadurch gekennzeichnet, daß die zweite Datenrate (Fp) größer ist als die erste Datenrate (Fb),

daß allen Daten (Bi) der ersten Quelle (1) wenigstens ein Abtastwert einer Reihe von Abtastwerten mit der zweiten Datenrate (Fp) zugeordnet werden,
die Abtastwerte einem Polyphasen-Filter (6) zugeführt werden, von dem jeder Koeffizientensatz einen Daten-Phasenfehler (Phase) zugeordnet wird, der vorher durch die Zuordnung eingeführt wurde, wobei der Phasenfehler der Verzögerung zwischen der theoretischen Lage eines durch die binäre Quelle gelieferten Bit und dem Abtastwert entspricht, dem er zugeordnet ist,
daß die gefilterten Abtastwerte in das digitale Signal eingefügt werden (8).

2. Verfahren nach Anspruch 1, dadurch gekennzeichnet, daß die Koeffizientensätze des Filters (6) aus der gewünschten Darstellung der Daten abgeleitet werden, die in dem digitalen Signal von der ersten Quelle (1) geliefert werden.

3. Verfahren nach Anspruch 2, dadurch gekennzeichnet, daß das Polyphasen-Filter (6) einen Speicher (11) enthält, der die möglichen Ergebnisse der Filterung beinhaltet, und daß der Speicher (11) für jeden laufenden Abtastwert des Fensters des Faltungsintegrals (C) des Filters einerseits durch eine Information (Phase), die den diesem Filter zugeordneten Phasenfehler darstellt, und andererseits durch eine Information (10) adressiert wird, die den Inhalt des Fensters des Faltungsintegrals darstellt.

4. Verfahren nach einem der vorangehenden Ansprüche, dadurch gekennzeichnet, daß die Zuordnung der Daten der ersten Quelle (1) zu den Abtastwerten, deren Datenrate (Fp) diejenige der zweiten Quelle (3) ist, derart erfolgt, daß im Mittelwert einige Daten der ersten Quelle im wesentlichen Q-Abtaswerten zugeordnet werden, wobei

$$Q = Fp/Fb$$

ist und wobei Fb und Fp jeweils die Datenrate der ersten und der zweiten Quelle sind.

5. Verfahren nach einem der vorangehenden Ansprüche, dadurch gekennzeichnet, daß die Zuordnung der Daten der ersten Quelle (1) zu den Abtastwerten, deren Datenrate (Fp) diejenige der zweiten Quelle ist, derart erfolgt, daß M Daten von der ersten Quelle N Abtastwerten zugeordnet werden, wobei M und N die kleinsten ganzen Zahlen sind, die die Gleichung

$$Fp/Fb = N/M$$

erfüllen,
und wobei Fb und Fp jeweils die Datenrate der ersten bzw. der zweiten Quelle sind.

6. Verfahren nach einem der Ansprüche 4 oder 5, dadurch gekennzeichnet, daß eine Datenfolge der ersten Quelle (1) wiederholt wird, solange das Maß der theoretischen Wiederholung geringer ist als das Maß der laufenden Wiederholung, und daß das Maß der theoretischen Wiederholung das Verhältnis Fp/Fb darstellt, und daß das Maß der laufenden Wiederholung gleich dem Verhältnis zwischen der Anzahl der gesendeten Abtastwerte und der Anzahl der verschiedenen, durch die erste Quelle (1) gelieferten Datenfolgen ist.

7. Verfahren nach Anspruch 6, dadurch gekennzeichnet, daß unter den Abtastwerten, die dieselbe Datenfolge (Bi) von der ersten Quelle (1) tragen, alle außer einer auf den Nullwert (Décime) gesetzt werden.

8. Verfahren nach Anspruch 7, dadurch gekennzeichnet, daß der auf seinem Anfangswert gehaltene Abtaswert der erste Abtastwert ist, der die von der ersten Quelle gelieferten Daten trägt.

9. Verfahren nach einem der Ansprüche 1-3, dadurch gekennzeichnet, daß die mit der Datenrate (Fp) der zweiten Quelle gelieferten Abtastwerte eine Datenfolge von der ersten Quelle (1) tragen, wenn das Maß der theoretischen Wiederholung größer wird als das Maß der laufenden Wiederholung, wobei das Maß der theoretischen Wiederholung gleich dem Verhältnis Fp/Fb ist, und daß das Maß der laufenden Wiederholung gleich dem Verhältnis zwischen der Anzahl der gelieferten Abtastwerte und der Anzahl der durch die erste Quelle gelieferten verschiedenen Daten ist, und daß alle enderen Abtaswerte bei einem Nullwert liegen.

10. Verfahren nach Anspruch 9, dadurch gekennzeichnet, daß bestimmte Abtastwerte X-mal wiederholt werden, wobei X gleich dem Verhältnis der theoretischen Wiederholung, abgerundet auf die nächste ganze Zahl, ist, und daß der erste Abtastwert, der auf eine Reihe von Abtastwerten folgt, die einer nicht X-mal wiederholten Datenfolge zugeordnet sind, einem Phasensprung unterworfen wird (Restaure).

11. Verfahren nach Anspruch 10, dadurch gekennzeichnet, daß die dem Polyphasenfilter (6) zugeführten Abtastwerte derart verschoben werden, daß jeder Phasensprung nicht in dem Fenster des Faltungsintegrals (C) erscheint.

12. Verfahren nach Anspruch 10 oder 11, dadurch gekennzeichnet, daß die Reihe von Abtastwerten das Fenster des Faltungsintegrals des Polyphasenfilters (6) durchläuft, wobei das Fenster einen Abtastwert enthält, der als laufender Abtastwert bezeichnet wird,

   - daß, solange ein Abtastwert bei dem Phasensprung nicht in das Fenster des Faltungsintegrals eingetreten ist, keine Änderung der Abtastwerte erfolgt,
   - daß, wenn ein Abtastwert bei dem Phasensprung links von dem laufendem Abtastwert liegt, dieser und die darauffolgenden um einen Abtastwert nach links verschoben werden,
   - daß, wenn ein Abtastwert beim Phasensprung der laufende Abtastwert ist oder wenn er rechts von dem laufenden Abtastwert liegt, seine Vorgänger um einen Abtastwert nach rechts verschoben werden.

13. Verfahren nach einem der vorangehenden Ansprüche, dadurch gekennzeichnet, daß die erste Quelle (1) eine binäre Quelle von Videotextdaten ist.

14. Verfahren nach einem der vorangehenden Ansprüche, dadurch gekennzeichnet, daß das digitale Signal ein Signal gemäß der digitalen Norm CCIR 601 ist.

15. Verfahren nach Anspruch 2, dadurch gekennzeichnet, daß die gewünschte Darstellung ähnlich ist dem Impuls, der einem in der Spezifikation des Videotext (Figur 1) definierten Bit entspricht.

16. Verfahren nach einem der vorangehenden Ansprüche, dadurch gekennzeichnet, daß die Koeffizientensätze folgendermaßen definiert sind:

$$C(P,X)=k*(0.5 + 0.5Cos(\pi(m*X + Fp*P))$$

   wobei

   X einen Koeffizienten innerhalb eines Satzes darstellt
   P den Phasenfehler für diesen Satz darstellt und wobei
   k eine Konstante ist,
   m eine Konstante ist, die von der Anzahl der Koeffizienten je
   Satz abhängig ist.

17. Einrichtung zum Einfügen von Abtastwerten, die digitale Daten von einer ersten Quelle mit einer ersten Datenrate (Fb) in einem digitalen Signal darstellen, das von einer zweiten Quelle mit einer zweiten Datenrate (Fp) geliefert wird, dadurch gekennzeichnet, daß
die zweite Datenrate größer ist als die erste Datenrate, daß die Einrichtung Mittel (2) zum Zuordnen der von der ersten Quelle gelieferten Daten zu einem oder mehreren Abtastwerten mit der Datenrate (Fp) der zweiten Quelle enthalten,

Polyphasen-Filtermittel (6) der Abtastwerte, deren Koeffizientensätze von den vorher durch die Zuordnung eingeführten Fehlern abhängig sind, wobei der Phasenfehler der Verzögerung zwischen der theoretischen Lage eines von der binären Quelle (1) gelieferten Bit und dem ihm zugeordneten Abtastwert entspricht,

Mittel zur Aufnahme (8) der gefilterten Abtastwerte in das digitale Signal.

18. Einrichtung nach Anspruch 17, dadurch gekennzeichnet, daß die Mittel zum Zuordnen Speichermittel mit der Anzahl der Abtastwerte enthalten, die jeder von der ersten Quelle gelieferten Datenfolge zuzuordnen sind.

19. Einrichtung nach Anspruch 17 oder 18, dadurch gekennzeichnet, daß die Einrichtung außerdem Mittel zur Dezimierung (7) der Abtastwertfolgen enthält, die die von der ersten Quelle gelieferten Datenfolgen führen und die Mittel zur Dezimierung alle dieselbe Datenfolge führenden Abtastwerte, außer einen Abtastwert, auf null setzen.

20. Einrichtung nach einem der Ansprüche 17 bis 19, dadurch gekennzeichnet, daß die Einrichtung ebenso ein Schieberegister (4) und Multiplexmittel (9) enthält, die derart gesteuert werden, daß die dem Filter zugeführten Abtastwerte keinen Phasensprung aufweisen.

21. Einrichtung nach einem der Ansprüche 17 bis 20, dadurch gekennzeichnet, daß die Polyphasen-Filtermittel Speichermittel (11) für die möglichen Ergebnisse der Filterung enthalten und die Speichermittel aufgrund des Inhalts des Fensters des Faltungsintegrals (10,C) des Filters und aufgrund der jedem Abtastwert (Phase) zugeordneten Phasenfehler adressiert werden.

22. Einrichtung nach einem der Ansprüche 17 bis 21, dadurch gekennzeichnet, daß sie das Verfahren gemäß einem der Ansprüche 1 bis 15 durchführt.

23. Einrichtung nach einem der Ansprüche 17 bis 22, dadurch gekennzeichnet, daß die Koeffizientensätze folgendermaßen definiert sind:

$$C(P,X)=k*(0.5 + 0.5Cos(\pi(0.25X + Fp*P))$$

wobei

X einen Koeffizienten innerhalb eines Satzes darstellt,
P den einem Satz zugeordneten Phasenfehler darstellt und
k eine Konstante ist.

24. Verfahren zur Einfügung von Abtastwerten, die erste digitale Daten mit einer ersten Datenrate (Fb) darstellen, in ein digitales Signal mit einer zweiten Datenrate (Fp), dadurch gekennzeichnet, daß

die zweite Datenrate (Fp) größer ist als die erste Datenrate (Fb),
daß jede der ersten Datenfolgen (Bi) wenigstens einem Abtastwert mit der zweiten Datenrate (Fp) zugeordnet wird,
daß eine Korrektur der ersten Datenfolgen in Abhängigkeit von den durch die Zuordnung eingeführten Phasenfehler durchgeführt wird, wobei der Phasenfehler der Verzögerung zwischen der theoretischen Lage eines von der binären Quelle (1) gelieferten Bit und dem Abtastwert entspricht, dem er zugeordnet ist, und
daß die derart korrigierten ersten Datenfolgen an der Stelle der Abtastwerte eingefügt werden, denen sie zugeordnet sind.

25. Verfahren nach Anspruch 24, dadurch gekennzeichnet, daß die genannte Korrektur durch ein Polyphasen-Filter (6) erfolgt, bei dem jeder Koeffizientensatz einem Phasenfehler (Phase) zugeordnet ist, der vorher durch die Zuordnung eingeführt wurde.

**Claims**

1. Process for inserting samples representing digital data emanating from a first source (1) having a first bit rate (Fb) into a digitized signal emanating from a second source (3) having a second bit rate (Fp), characterized in that,

the second bit rate (Fp) being greater than the first bit rate (Fb),
each datum (Bi) from the first source (1) is associated with at least one sample of a series of samples at the second bit rate (Fp),
the samples being presented to a polyphase filter (6), each set of coefficients of which being associated with a phase error (Phase) previously introduced by said association, the phase error corresponding to the delay between the theoretical position of a bit emanating from the binary source (1) and the sample with which it is associated,
the filtered samples being included (8) within the digitized signal.

2. Process according to Claim 1, characterized in that the sets of coefficients of the filter (6) are deduced from the desired representation of the data emanating from the first source (1) in the digitized signal.

3. Process according to Claim 2, characterized in that the polyphase filter (6) comprises a memory (11) comprising the possible results of the filtering, the said memory (11) being addressed for each current sample of the convolution window (C) of the filter, on the one hand by a cue (Phase) representing the phase error associated with this filter and on the other hand by a cue (10) representing the contents of the convolution window.

4. Process according to one of the preceding claims, characterized in that the association of the data from the first source (1) with samples whose bit rate (Fp) is that of the second source (3) is effected in such a way that on average, a datum from the first source is associated substantially with Q samples, where

$$Q = Fp/Fb$$

and where Fb and Fp are the bit rates of the first and of the second source respectively.

5. Process according to one of the preceding claims, characterized in that the association of the data from the first source (1) with samples whose bit rate (Fp) is that of the second source is effected in such a way that M data emanating from the first source are associated with N samples, where M and N are the smallest integers satisfying

$$Fp/Fb = N/M$$

and where Fb and Fp are the bit rates of the first and of the second source respectively.

6. Process according to one of Claims 4 or 5, characterized in that a datum from the first source (1) is repeated as long as the theoretical repetition factor is less than the current repetition factor, the theoretical repetition factor being the ratio Fp/Fb, the current repetition factor being the ratio of the number of samples transmitted to the number of different data transmitted by the first source (1).

7. Process according to Claim 6, characterized in that all except one of the samples bearing one and the same datum (Bi) emanating from the first source (1) are forced to the zero value (Decimate).

8. Process according to Claim 7, characterized in that the sample maintained at its initial value is the first sample bearing the said datum emanating from the first source.

9. Process according to one of Claims 1 to 3, characterized in that the said samples transmitted at the bit rate (Fp) of the second source bear a datum emanating from the first source (1) when the theoretical repetition factor becomes greater than the current repetition factor, the theoretical repetition factor being the ratio Fp/Fb; the current repetition factor being the ratio of the number of samples transmitted to the number of different data transmitted by the first source, and in that all the other samples bear a zero value.

10. Process according to Claim 9, characterized in that certain samples being repeated X times, where X is equal to the theoretical repetition ratio rounded to the nearest integer, the first sample following a series of samples associated with a datum which is not repeated X times is said to be in a condition of phase break (Restore).

11. Process according to Claim 10, characterized in that the samples presented to the polyphase filter (6) are shifted in such a way that no phase break appears in the convolution window (C).

12. Process according to Claim 10 or 11, characterized in that the series of samples travels across the convolution window of the polyphase filter (6), the said window comprising a sample termed the current sample,

- as long as no sample in a condition of phase break has entered the convolution window, no modification of the samples has occurred,
- when a sample in a condition of phase break is to the left of the current sample, it and its successors are shifted leftwards by one sample,
- when a sample in a condition of phase break is the current sample or when it lies to the right of the current sample, its predecessors are shifted rightwards by one sample.

13. Process according to one of the preceding claims, characterized in that the said first source (1) is a binary source of teletext data.

14. Process according to one of the preceding claims, characterized in that the said digitized signal is a signal to the CCIR 601 digital standard.

15. Process according to Claim 2, characterized in that the said desired representation is similar to the pulse corresponding to a bit, which is defined in the Teletext specification (Figure 1).

16. Process according to one of the preceding claims, characterized in that the sets of coefficients are defined by:

$$C(P,X) = k*(0.5 + 0.5 \, \mathrm{Cos}(\pi(m*X + Fp*P))$$

where

X represents a coefficient inside a set
P represents the phase error associated with this set and where
k is a constant,
m is a constant dependent on the number of coefficients per set.

17. Device for inserting samples representing digital data emanating from a first source having a first bit rate (F6) into a digitized signal emanating from a second source having a second bit rate, (Fp) characterized in that,

the second bit rate being greater than the first bit rate, said device comprises means (2) for associating the data emanating from the first source with one or more samples at the bit rate (Fp) of the second source, means (6) for polyphase filtering of said samples whose sets of coefficients depend on the phase errors previously introduced by said association, the phase error corresponding to the delay between the theoretical position of a bit emanating from the binary source (1) and the sample with which it is associated, means (8) for including the filtered samples in the digitized signal.

18. Device according to Claim 17, characterized in that the said associating means comprise means for storing the number of samples to be associated with each datum emanating from the first source.

19. Device according to Claim 17 or 18, characterized in that the device also comprises means (7) for decimating the sequence of samples bearing the data emanating from the first source, the said decimating means forcing all except one of the samples bearing the same datum to zero.

20. Device according to one of Claims 17 to 19, characterized in that the device also comprises a shift register (4) and multiplexing means (9) controlled in such a way that the samples presented to the filter do not present any phase break.

21. Device according to one of Claims 17 to 20, characterized in that the polyphase filtering means comprise means of storage (11) of the possible results of the said filtering, the said means of storage being addressed by virtue of the contents of the convolution window (10, C) of the filter and by virtue of the phase errors associated with each sample (Phase).

22. Device according to one of Claims 17 to 21, characterized in that it employs the process according to one of Claims 1 to 15.

23. Device according to one of Claims 17 to 22, characterized in that the sets of coefficients are defined by:

$$C(P,X) = k*(0.5 + 0.5\, Cos(\pi(0.25X + Fp*P))$$

where

X represents a coefficient inside a set
P represents the phase error associated with this set and where
k is a constant.

24. Process for inserting samples representing first digital data having a first bit rate (Fb) into a digitized signal having a second bit rate (Fp), characterized in that

the second bit rate (Fp) being greater than the first bit rate (Fb),
each of the first data (Bi) is associated with at least one sample at the second bit rate (Fb),
a correction is made to the first data as a function of the phase error introduced by the said association, the phase error corresponding to the delay between the theoretical position of a bit emanating from the binary source (1) and the sample with which it is associated, and
the said first data thus corrected are inserted in place of the samples with which they are associated.

25. Process according to Claim 24, characterized in that the said correction is carried out by a polyphase filter (6), each set of coefficients of which is associated with a phase error (Phase) previously introduced by the said association.

FIG. 1

EP 0 690 623 B1

FIG.2

FIG.3

EP 0 690 623 B1

EP 0 690 623 B1

| | ECHANTILLON | 47 46 45 44 | 43 42 41 40 | 39 38 37 | 36 35 34 33 | 32 31 30 29 | 28 27 26 25 |
|---|---|---|---|---|---|---|---|
| **4a** | BIT EN SORTIE DE PROTOCOLE | $B_{12}\,B_{12}\,B_{12}\,B_{12}$ | $B_{11}\,B_{11}\,B_{11}\,B_{11}$ | $B_{10}\,B_{10}\,B_{10}$ | $B_9\,B_9\,B_9\,B_9$ | $B_8\,B_8\,B_8\,B_8$ | $B_7\,B_7\,B_7\,B_7$ |
| **4b** | DÉCIMATION | $\phi\ \phi\ \phi\ B_{12}$ | $\phi\ \phi\ \phi\ B_{11}$ | $\phi\ \phi\ B_{10}$ | $\phi\ \phi\ \phi\ B_9$ | $\phi\ \phi\ \phi\ B_8$ | $\phi\ \phi\ \phi\ B_7$ |
| **4c** | RESTAURATION | $\phi\ \phi\ \phi\ \phi$ | $\phi\ \phi\ \phi\ \phi$ | $\phi\ \phi\ 1$ | $\phi\ \phi\ \phi\ \phi$ | $\phi\ \phi\ \phi\ \phi$ | $\phi\ \phi\ \phi\ \phi$ |

| | ECHANTILLON | 24 23 22 21 | 20 19 18 17 | 16 15 14 13 | 12 11 10 9 | 8 7 6 5 | 4 3 2 1 |
|---|---|---|---|---|---|---|---|
| **4a** | BIT EN SORTIE DE PROTOCOLE | $B_6\,B_6\,B_6\,B_6$ | $B_5\,B_5\,B_5\,B_5$ | $B_4\,B_4\,B_4\,B_4$ | $B_3\,B_3\,B_3\,B_3$ | $B_2\,B_2\,B_2\,B_2$ | $B_1\,B_1\,B_1\,B_1$ |
| **4b** | DÉCIMATION | $\phi\ \phi\ \phi\ B_6$ | $\phi\ \phi\ \phi\ B_5$ | $\phi\ \phi\ \phi\ B_4$ | $\phi\ \phi\ \phi\ B_3$ | $\phi\ \phi\ \phi\ B_2$ | $\phi\ \phi\ \phi\ B_1$ |
| **4c** | RESTAURATION | $\phi\ \phi\ \phi\ \phi$ | $\phi\ \phi\ \phi\ \phi$ | $\phi\ \phi\ \phi\ \phi$ | $\phi\ \phi\ \phi\ \phi$ | $\phi\ \phi\ \phi\ \phi$ | $\phi\ \phi\ \phi\ \phi$ |

## FIG.4

EP 0 690 623 B1

FIG.5

FIG. 6

FIG.7